# EUROPÄISCHE PATENTANMELDUNG

(11) **EP 3 971 596 A1**
(43) Veröffentlichungstag der Anmeldung: **23.03.2022**
(21) Anmeldenummer: 21194542.3
(22) Anmeldetag: 02.09.2021
(51) Int. Cl.: G01R 31/367, G01R 31/392

(54) **VERFAHREN ZUM BETREIBEN EINER BATTERIE FÜR EINE ZWEITE LEBENSDAUER**

(30) Priorität: 21.09.2020 DE 102020211763
(71) Anmelder: Robert Bosch GmbH, 70442 Stuttgart (DE)
(72) Erfinder: Tiefenbach, Andy, 71665 Vaihingen-Horrheim (DE); Gleiter, Andreas, 70437 Stuttgart (DE); Manka, Daniel, 74343 Sachsenheim (DE)

(57) **Zusammenfassung**

Verfahren zum Betreiben einer Batterie für eine zweite Lebensdauer ("Second-Life-Betrieb").

## Beschreibung

Die Erfindung geht aus von einem Verfahren zum Betreiben einer Batterie für eine zweite Lebensdauer ("Second-Life-Betrieb"), einer Vorrichtung zum Betrieb einer Batterie, einem Computerprogramm sowie einer Verwendung einer Vorrichtung zum Betrieb einer Batterie gemäß dem Oberbegriff der unabhängigen Ansprüche.

### Stand der Technik

Insbesondere Lithium-Ionen-Batterien sind nach einem Fahrzeugleben noch weiterhin für stationäre Energiespeicher nutzbar. Dabei können sie einen relevanten Anteil bei der Energiewende beitragen.

Allerdings nutzen aktuelle Batterien für Elektrofahrzeuge häufig Steuergeräte (Batterie-Management-Systeme, "BMS"), die überwiegend auf einen Betrieb im jeweiligen Fahrzeug optimiert sind und daher beispielsweise keinen universellen Kommunikationsstandard aufweisen.

Eine Integration herstellerspezifischer Batteriesysteme in stationäre Anwendungen ist daher sehr aufwändig und umfasst häufig eine kostenintensive Vorab-Vermessung jeder einzelnen Batterie.

Das Dokument US 2019 334 213 A1 offenbart ein Batterieinformationsverarbeitungssystem umfassend eine Steuervorrichtung, die konfiguriert ist, um eine Kapazitätsberechnungsverarbeitung durchzuführen.

Das Dokument US 2014 015 537 A1 offenbart ein Steuersystem für eine Batteriebaugruppe zum Bestimmen, ob die Batteriebaugruppe wiederverwendet werden kann, indem erfasste Werte der Ruhespannung, des Innenwiderstands und der vollen Ladekapazität jeder der Batterien als Bewertungsparameter verwendet werden.

Es ist Aufgabe der vorliegenden Erfindung, den Stand der Technik weiter zu verbessern. Diese Aufgabe wird gelöst durch die Merkmale der unabhängigen Ansprüche.

### Offenbarung der Erfindung

### Vorteile der Erfindung

Die erfindungsgemäße Vorgehensweise mit den kennzeichnenden Merkmalen der unabhängigen Ansprüche weist demgegenüber den Vorteil auf, dass das Verfahren zum Betreiben einer Batterie für eine zweite Lebensdauer ("Second-Life-Betrieb") folgende Schritte umfasst:
- Aktivieren der Batterie mittels einer Steuereinheit und Erfassen eines Spannungswerts, der eine elektrische Spannung der Batterie repräsentiert;
- Starten der Batterie mit einer im Vergleich zu einem Normalbetrieb wesentlich geringeren elektrischen Leistung und schrittweises Erhöhen eines Stromwerts, der einen maximal zulässigen elektrischen Strom repräsentiert,
- wobei der Stromwert einem mit der Batterie elektrisch verbindbaren Wechselrichter übermittelt wird,
- wobei für jede Ladung und Entladung der Batterie Spannungswerte und Stromwerte erfasst werden, und
- Parametrierung eines Ersatzschaltbildmodells der Batterie unter Verwendung der Spannungswerte und/oder Stromwerte zum Erlernen und Optimieren von Batterieparametern.

Durch das erfindungsgemäße Verfahren können kontinuierlich Batterieparameter von Batterien mit einer unbekannten Betriebsstrategie erlernt und optimiert werden.

Während die Parameter einer Traktionsbatterie nicht auf einen stark gealterten Betrieb der Batterie ausgelegt sind, stellt das erfindungsgemäße Verfahren eine Nutzung über die weiter zunehmende Alterung sicher, die auch weit über die Nutzungsdauer der Erstanwendung ("End-of-Life") hinausgeht, Dadurch wird vorteilhafterweise ein adaptiver Betrieb einer Batterie für eine zweite Lebensdauer ("Second-Life-Betrieb") ermöglicht.

Die Batterieparameter umfassen eine Ruhespannung, ein dynamisches Verhalten, eine Temperatur, eine elektrische Spannung, einen Innenwiderstand, einen Ladezustand, einen Alterungszustand und/oder eine Leistungsfähigkeit der Batterie.

Die Steuereinheit ist von der Batterie räumlich getrennt. Durch eine externe Steuereinheit kann vorteilhafterweise unabhängig von herstellerspezifischen Batteriemanagementsystemen diese externe Steuereinheit als adaptives Batteriemanagementsystem zur Verwendung der Batterie für eine zweite Lebensdauer ("Second-Life-Betrieb") genutzt werden. Das erfindungsgemäße Verfahren ermöglicht weiter einen Betrieb verschiedener Batteriesysteme, da deren jeweilige Eigenschaften vom adaptiven Batteriemanagementsystemen erlernt werden.

Während in einer Fahrzeuganwendung die Batterieströme unmittelbar dem Fahrerwunsch entsprechen müssen, sind diese während eines Betriebs der Batterie in einer zweiten Lebensdauer in einem gewissen Bereich wählbar. Weiter liegen ein Temperaturbereich und Nutzleistungsanforderungen in einem eingeschränkten und für die Batterie optimalen Bereich. Dies erlaubt ein erfindungsgemäßes iteratives Verfahren zum Ermitteln von Betriebsgrenzen, eines Abschaltverhaltens und/oder eines Leistungsspektrums der Batterie.

Eine erfindungsgemäße Vorrichtung zum Betrieb einer Batterie umfasst einen Wechselrichter sowie mindestens ein Mittel, insbesondere eine elektronische Steuereinheit, welche eingerichtet sind, die Schritte eines erfindungsgemäßen Verfahrens durchzuführen.

Gemäß einer vorteilhaften Ausgestaltung der Erfindung ist ein Computerprogramm vorgesehen, umfassend Befehle, die bewirken, dass die Vorrichtung zum Betrieb einer die erfindungsgemäßen Verfahrensschritte ausführt.

Ferner ist ein maschinenlesbares Speichermedium vorgesehen, auf dem das Computerprogramm gespeichert ist.

Eine erfindungsgemäße Vorrichtung zum Betrieb einer Batterie findet vorteilhafterweise Verwendung in stationären Speichern zur Speicherung insbesondere regenerativ gewonnener elektrischer Energie.

Es zeigen:
Figur 1 eine schematische Darstellung einer Ausführungsform einer erfindungsgemäßen Vorrichtung; und
Figur 2 eine schematische Darstellung eines Ersatzschaltbildmodells einer Batterie; und
Figur 3 eine schematische Darstellung eines Ablaufdiagramms einer Ausführungsform eines erfindungsgemäßen Verfahrens.

### Detaillierte Beschreibung der Ausführungsbeispiele

Gleiche Bezugszeichen bezeichnen in allen Figuren gleiche Vorrichtungskomponenten.

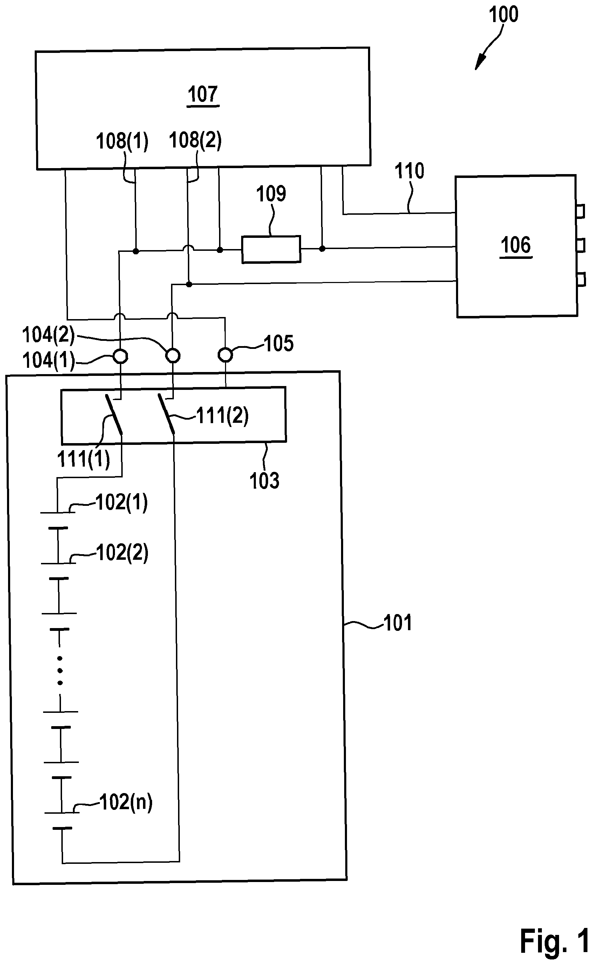

Figur 1 zeigt eine schematische Darstellung einer Ausführungsform einer erfindungsgemäßen Vorrichtung 100. Die Vorrichtung 100 umfasst eine Batterie 101 mit einer Vielzahl von Batteriezellen 102(1), 102(2), 102(n), ein batteriespezifisches Batteriemanagementsystem 103 mit Schaltern 111(1), 111(2) zum elektrischen Kontaktieren der Batteriezellen 102(1), 102(2), 102(n) mit Anschlusspolen 104(1), 104(2) der Batterie 101. Die Anschlusspole 104(1), 104(2) sind mit einem Wechselrichter 106 elektrisch verbunden. Ferner weist die Batterie einen Steuereingang 105 auf, beispielsweise zum Ein- und Ausschalten des Batteriemanagementsystems 103 durch eine externe Steuereinheit 107. Die externe Steuereinheit 107 erfasst elektrische Spannungen der Anschlusspole 104(1), 104(2) mit Spannungssensoren 108(1), 108(2) sowie einen elektrischen Strom mittels einem Stromsensor 109. Weiter ist die externe Steuereinheit 107 mit dem Wechselrichter 106 über eine Signalleitung 110 verbunden.

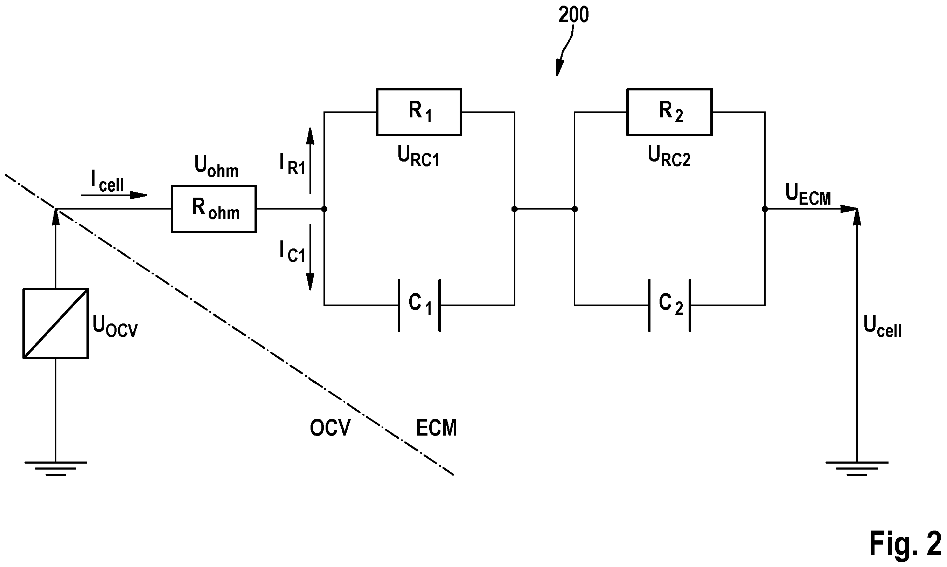

Figur 2 zeigt eine schematische Darstellung eines Ersatzschaltbildmodells einer Batterie 200. Als Ersatzschaltbildmodells kann beispielsweise eine Serienschaltung von ein oder mehreren RC-Gliedern und einem ohmschen Widerstand verwendet werden.

Durch das erfindungsgemäße Verfahren werden Batterieparameter erlernt, beispielsweise eine Ruhespannung, ein dynamisches Verhalten, eine Temperatur, eine elektrische Spannung, einen Innenwiderstand, einen Ladezustand, einen Alterungszustand und/oder eine Leistungsfähigkeit der Batterie 200.

Da vorgegebene-Grenzen für Laden und Entladen der Batterie 200 unterschiedlich sein können, wird das Ersatzschaltbildmodells für Laden und Entladen getrennt parametrisiert.

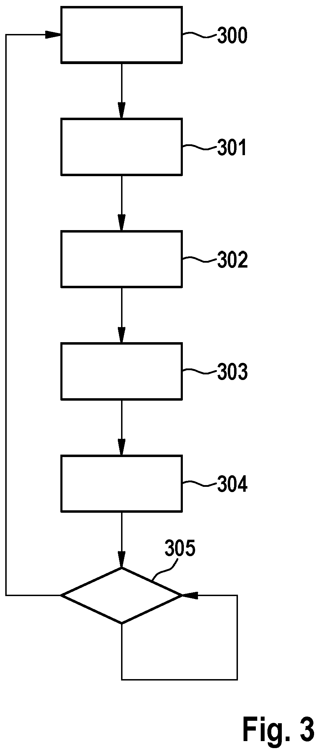

Figur 3 zeigt eine schematische Darstellung eines Ablaufdiagramms einer Ausführungsform eines erfindungsgemäßen Verfahrens. In Schritt 300 wird das Verfahren gestartet und eine Batterie mittels einer Steuereinheit, beispielsweise über einen OEM-Key, aktiviert.

In Schritt 301 wird eine elektrische Spannung der Batterie erfasst.

In Schritt 302 wird die Batterie mit einem im Vergleich zu einem Normalbetrieb wesentlich geringeren Strom, also einer geringeren Leistung, gestartet. Ein zulässiges Stromlimit wird an einen Umrichter kommuniziert.

In Schritt 303 werden elektrische Spannungen und Ströme gemessen und ausgewertet. Durch die erfassten elektrischen Spannungen und Ströme kann ein Ersatzschaltbildmodell der Batterie in Schritt 304 parametriert werden.

Da vorgegebene Grenzen für Laden und Entladen unterschiedlich sein können, wird das Ersatzschaltbildmodell der Batterie für jeweils Laden und Entladen parametrisiert. Als Ersatzschaltbildmodell der Batterie kann beispielsweise eine Serienschaltung von mindestens einem RC-Glied und einem ohmschen Widerstand verwendet werden.

Wird in Schritt 305 ein Relaisöffner erkannt, wird die Batterie in Schritt 300 neu gestartet und bei einer geringeren Stromstärke betrieben.

## Patentansprüche

1. Verfahren zum Betreiben einer Batterie (100, 200) für eine zweite Lebensdauer ("Second-Life-Betrieb"), umfassend folgende Schritte:
- (300, 301) Aktivieren der Batterie (100, 200) mittels einer Steuereinheit (107) und Erfassen eines Spannungswerts, der eine elektrische Spannung der Batterie (100, 200) repräsentiert;
- (302) Starten der Batterie (100, 200) mit einer im Vergleich zu einem Normalbetrieb wesentlich geringeren elektrischen Leistung und schrittweises Erhöhen eines Stromwerts, der einen maximal zulässigen elektrischen Strom repräsentiert,
- wobei der Stromwert einem mit der Batterie (100, 200) elektrisch verbindbaren Wechselrichter (106) übermittelt wird,
- (303) wobei für jede Ladung und Entladung der Batterie (100, 200) Spannungswerte und Stromwerte erfasst werden, und
- (304) Parametrierung eines Ersatzschaltbildmodells der Batterie (100, 200) unter Verwendung der Spannungswerte und/oder Stromwerte zum Erlernen und Optimieren von Batterieparametern.

2. Verfahren zum Betreiben einer Batterie (100, 200) gemäß Anspruch 1, wobei die Batterieparameter eine Ruhespannung, ein dynamisches Verhalten, eine Temperatur, eine elektrische Spannung, einen Innenwiderstand, einen Ladezustand, einen Alterungszustand und/oder eine Leistungsfähigkeit der Batterie (100, 200) umfassen.

3. Verfahren zum Betreiben einer Batterie (100, 200) gemäß einem der vorhergehenden Ansprüche, wobei die Steuereinheit (107) von der Batterie (100, 200) räumlich getrennt ist.

4. Vorrichtung zum Betrieb einer Batterie (100, 200), umfassend einen Wechselrichter (106) sowie mindestens ein Mittel, insbesondere eine elektronische Steuereinheit (107), welche eingerichtet sind, die Schritte des Verfahrens nach einem der Ansprüche 1 bis 3 durchzuführen.

5. Computerprogramm, umfassend Befehle, die bewirken, dass die Vorrichtung nach Anspruch 4 die Verfahrensschritte nach einem der Ansprüche 1 bis 3 ausführt.

6. Maschinenlesbares Speichermedium, auf dem das Computerprogramm nach Anspruch 5 gespeichert ist.

7. Verwendung einer Vorrichtung gemäß Anspruch 4 in stationären Speichern zur Speicherung insbesondere regenerativ gewonnener elektrischer Energie.
